Europäisches Patentamt

**European Patent Office**

**Office européen des brevets**

(19)

(11) Publication number: **0 164 094**
A2

(12)

# EUROPEAN PATENT APPLICATION

(21) Application number: 85106856.9

(22) Date of filing: 04.06.85

(51) Int. Cl.⁴: **H 01 L 29/78,** H 01 L 29/10

(30) Priority: 08.06.84 US 618442

(43) Date of publication of application: **11.12.85 Bulletin 85/50**

(84) Designated Contracting States: **DE FR GB NL**

(71) Applicant: **EATON CORPORATION, Eaton Center 111 Superior Ave., Cleveland Ohio 44114 (US)**

(72) Inventor: **Benjamin, James Anthony, 20865 Hawthorn Ridge Court, Waukesha Wisconsin 53186 (US)**
Inventor: **Lade, Robert Walker, 1009 North Jackson Street Apartment 2302, Milwaukee Wisconsin 43202 (US)**
Inventor: **Schutten, Herman Peter, 8545 North Fielding Road, Bayside Wisconsin 53217 (US)**

(74) Representative: **Wagner, Karl H., WAGNER & GEYER Patentanwälte Gewuerzmuehistrasse 5 Postfach 246, D-8000 München 22 (DE)**

(54) **Isolated bidirectional power fet.**

(57) A bidirectional power FET (2) is provided with a vertical isolation region (6) of semiconductor material affording AC blocking capability in an OFF state, and through which a horizontal conduction channel (16) is induced in an ON state, for AC conduction.

**EP 0 164 094 A2**

C3-TK3-408
0164094

# ISOLATED BIDIRECTIONAL POWER FET

## Background And Summary

The invention relates to power switching semiconductors, and more particularly to power MOSFETs (metal oxide semiconductor field effect transitors), and the like.

The invention provides FET structure for bidirectional power switching, including AC application. Enhanced AC blocking capability is provided by a vertical isolation region of semiconductor material forming blocking junctions on the vertical sides thereof. In the ON state, a bidirectional conduction channel is induced laterally through the isolation region.

## Brief Description Of The Drawings

FIG. 1 is a schematic sectional substrate diagram of power FET structure in accordance with the invention.

FIG. 2 shows an alternative gating arrangement for the structure of FIG. 1.

FIGS. 3 and 4 illustrate processing steps for the structure of FIG. 1.

## Detailed Description

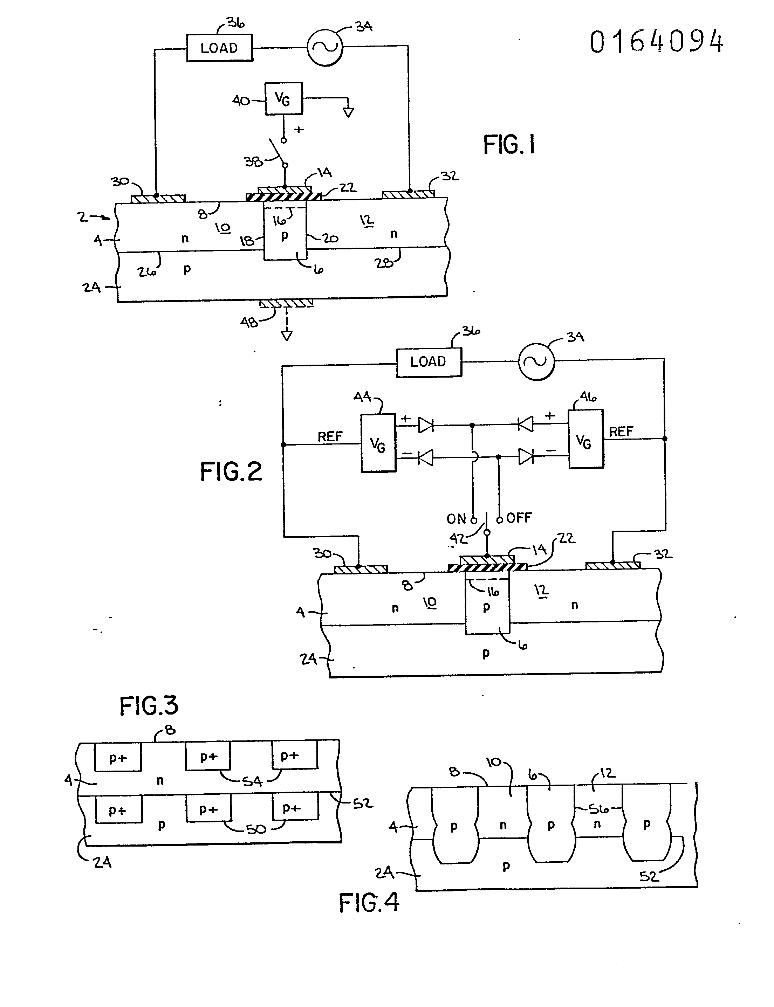

Referring to FIG. 1, there is shown isolated bidirectional power FET structure 2 including a horizontal layer 4 of semiconductor material of one conductivity type such as n type. A vertical isolation region 6 of opposite conductivity type such as p type extends from top major surface 8 of layer 4 downwardly therethrough to isolate first and second n type regions 10 and 12 on opposite sides of p type vertical isolation region 6. Gate electrode means 14 is provided proximate isolation region 6 for applying an electric field to convert a portion of the latter to n type conductivity and provide a bidirectional conduction channel 16 between regions 10 and 12. FET 2 has an OFF state in the absence of the noted electric field, reverting channel 16 back to p type to block current flow between regions 10 and 12. Junction 18 between first n region 10 and p isolation region 6 blocks current flow in the rightward direction, and junction 20 between second n region 12 and p isolation region 6 blocks current flow in the leftward direction.

Gate electrode 14 extends along top major surface 8 and is spaced above isolation region 6 by a dielectric layer 22. Positive biasing potential or voltage on gate electrode 14 attracts electrons in p region 6 toward top major surface 8 beneath the gate electrode, and converts the portion of region 6 beneath the top major surface to n type, to thus induce a conduction channel 16 extending horizontally through isolation region 6 beneath top major surface 8. Current may then flow in either direction between first and second n regions 10 and 12 through induced n channel 16.

In preferred form, a horizontal sublayer 24 of the noted opposite conductivity type such as p type is below horizontal layer 4. Vertical p isolation region 6 extends downwardly into sublayer 24, and the sublayer blocks current flow between first and second n regions 10 and 12 around the bottom of p isolation region 6. Junction 26 between first n layer 10 and p sublayer 24 blocks current flow in one direction, i.e. rightwardly around the bottom of region 6. Junction 28 between second n region 12 and p sublayer 24 blocks current flow in the opposite direction, i.e. leftwardly around the bottom of region 6.

First and second main electrodes 30 and 32 are connected respectively to first and second n regions 10 and 12. The main electrodes are connectable in an AC load line, including AC power source 34 and load 36. Gate electrode 14 is connectable through a switch 38 to a source of gate potential 40. An ON state is provided by biasing gate electrode 14 with gate potential to apply an electric field to convert the portion of p isolation region 6 beneath top major surface 8 to n conductivity type and induce a conduction channel 16 through region 6 between first and second n regions 10 and 12 during each half cycle of the AC line such that there is bidirectional field effect conduction between regions 10 and 12 through channel 16. The roles of regions 10 and 12 are reversed in alternate half cycles. In the first half cycle, with left main electrode 30 positive with respect to right main electrode 32, current flows from region 10 rightwardly through channel 16 to region 12, with region 12 acting as a source and region 10 acting as a drain. During the second half cycle of the AC line, with right main electrode 32 positive with respect to left main electrode 30, current flows in the opposite direction, i.e. from region 12 leftwardly through channel 16 to region 10, with region 12 acting as a drain and region 10 acting as a source.

FET 2 has an OFF state in the absence of the noted gate potential to eliminate the conduction channel. Current flow rightwardly during the first half cycle is blocked by junction 18, and current flow leftwardly during the second half cycle is blocked by junction 20, whereby to provide AC blocking capability. In one form, the OFF state is provided by removing gate potential from gate electrode 14 and applying opposite polarity gate potential to electrode 14 to prevent attraction of minority carriers in isolation region 6 toward top major surface 8, to prevent unwanted inducement of a conduction channel during the OFF state.

FIG. 2 shows the preferred gating arrangement, and like reference numerals are used as in FIG. 1 where appropriate to facilitate understanding. In the ON state, switch 42 is in its leftward position. In the first half cycle of the AC line with left main electrode 30 positive with respect to right main electrode 32, gate electrode 14 is biased positively from gating voltage source 44 with respect to reference electrode 30. In the second half cycle, with right main electrode 32 positive with respect to left main electrode 30, gate electrode 14 is biased positively from gating voltage source 46 relative to reference electrode 32. During the ON state, gate electrode 14 thus attracts electrons in region 6 to invert the conductivity thereof beneath top major surface 8 to n type and form a conduction channel 16 between regions 10 and 12.

In the OFF state, switch 42 is in its rightward position such that gate electrode 14 is biased negatively relative to respective reference terminals 30 and 32 during respective first and second half cycles. Gate electrode 14 thus will not attract electrons toward top surface 8, to thus prevent unwanted inducement of a conduction channel at 16 during the OFF state.

FIG. 2 shows the gating voltage referenced to the main electrodes. Alternatively, the gating voltage may have its own dedicated reference, as shown in FIG. 1. Sublayer 24 may be connected as shown by dashed electrode 48 to the same reference level as gating voltage source 40.

Referring to FIGS. 3 and 4, the structure is initiated with horizontal p type sublayer 24. A plurality of p+ regions 50 are implanted in top surface 52 of layer 24, followed by epitaxial growth of n type top layer 4. A plurality of p+ regions 54 are implanted in top surface 8 of layer 4. The implanted regions 50 and 54 are thermally grown, as by a drive-in diffusion, vertically toward each other to meet and form p type vertical isolation regions 56, FIG. 4, corresponding to region 6 of FIG. 1 and separating first and second n type regions such as 10 and 12 on opposite sides thereof in top layer 4.

It is recognized that various modifications are possible within the scope of the appended claims.

## CLAIMS

1. Isolated bidirectional power FET structure comprising a horizontal layer of semiconductor material of one conductivity type having a vertical isolation region of opposite conductivity type extending from a top major surface of said layer downwardly therethrough to isolate first and second regions of said one conductivity type on opposite sides of said vertical isolation region of said opposite conductivity type, and gate electrode means proximate said isolation region for applying an electric field to convert a portion of the latter to said one cnductivity type and provide a bidirectional conduction channel between said first and second regions.

2. The invention according to claim 1 wherein said FET has an OFF state in the absence of said electric field, reverting said channel back to said opposite conductivity type to block current flow between said first and second regions, the junction between said first region and said isolation region blocking current flow in one direction, and the junction between said second region and said isolation region blocking current flow in the opposite direction.

3. The invention according to claim 2 wherein said gate electrode means extends along said top major surface and is spaced above said isolation region by a dielectric layer.

4. The invention according to claim 3 wherein said converted conduction channel extends horizontally through said isolation region beneath said top major surface.

5. The invention according to claim 2 comprising a horizontal sublayer of semiconductor material of said opposite conductivity type below said horizontal layer of semiconductor material of said one conductivity type, and wherein said vertical isolation region of said opposite conductivity type extends downwardly through said first mentioned layer and into said sublayer, said sublayer blocking current flow between said first and second regions around the bottom of said isolation region, the junction between said first region and said sublayer blocking current flow in one direction, and the junction between said second region and said sublayer blocking current flow in the opposite direction.

6. The invention according to claim 1 comprising first and second main electrodes connected respectively to said first and second regions, and wherein:

said main electrodes are connectable in an AC load line;

said gate electrode means is connectable to a source of gate potential for biasing said gate electrode to apply said electrid field and induce said conduction channel through said isolation region between said first and second regions during each half cycle of said AC line;

such that during the first half cycle of said AC line, current flows from said first main electrode through said first region then through said conduction channel then through said second region to said second main electrode;

and such that during the second half cycle of said AC line, current flows from said second main electrode through said second region then through said conduction channel then through said first region to said first main electrode.

7. Isolated bidirectional power FET structure, comprising:

a horizontal layer of semiconductor material of one conductivity type having a top major surface;

a vertical isolation region of opposite conductivity type extending from said top major surface of said layer downwardly through said layer to isolate first and second regions of said one conductivity type on opposite sides of said vertical isolation region;

first and second main electrodes connected respectively to said first and second regions, and connectable in an AC load line;

gate electrode means proximate and electrically isolated from said isolation region and connectable to a source of gate potential for biasing said gate electrode to apply an electric field to convert a portion of said isolation region to said one conductivity type and induce a conduction channel through said isolation region between said first and second regions during each half cycle of the AC line such that there is bidirectional field effect conduction between said first and second regions, with their roles reversed in alternate half cycles, such that current flows in one direction during the first half cycle with said first region acting as a drain and said second region acting as a source, and such that current flows in the opposite direction during the second half cycle with said second region acting as a drain and said first region acting as a source;

said FET having an OFF state in the absence of said gate potential to eliminate said conduction channel, current flow in one direction during the first half cycle being blocked by the junction between said vertical isolation region and one of said first and second regions, current flow in the opposite direction during the second half cycle being blocked by the junction between said vertical isolation region and the other of said first and second regions, whereby to provide AC blocking capability.

8. The invention according to claim 7 comprising a horizontal sublayer of semiconductor material of said opposite conductivity type below said horizontal layer of semiconductor material of said one conductivity type, and wherein:

said vertical isolation region extends downwardly through said first mentioned layer and into said sublayer;

said sublayer blocks current flow between said first and second regions around the bottom of said isolation region, the junction between said first region and said sublayer blocking current flow in one direction, and the junction between said second region and said sublayer blocking current flow in the opposite direction;

said gate electrode extends along said top major surface and is spaced above said isolation region;

and said conduction channel extends horizontally through said isolation region beneath said top major surface.

9. The invention according to claim 7 wherein said OFF state is provided by removing said gate potential from said gate electrode and applying opposite polarity gate potential to said gate electrode to prevent attraction of minority carriers in said isolation region, to prevent unwanted inducement of a conduction channel during said OFF state.

10. Isolated bidirectional power FET structure comprising a horizontal top layer of semiconductor material of one conductivity type formed on a horizontal sublayer of semiconductor material of opposite conductivity type, said top layer and said sublayer each having an implanted region of said opposite conductivity type, said implanted regions being thermally grown vertically toward each other to meet and form a vertical isolation region of said opposite conductivity type separating first and second regions of said one conductivity type on opposite sides thereof in said top layer, and gate electrode means proximate said isolation region for applying an electric field to convert a portion of the latter to said one conductivity type and provide a bidirectional conduction channel between said first and second regions.

11. The invention according to claim 10 wherein said implanted region in said sublayer is formed from a top surface thereof, and wherein said implanted region in said top layer is formed from a top surface thereof, said implanted regions being thermally grown to spread vertically through said top layer such that said vertical isolation region of said opposite conductivity type extends from said top surface of said top layer downwardly through said top layer and into said sublayer.

FIG.1

FIG.2

FIG.3

FIG.4

0164094